# EUROPÄISCHE PATENTSCHRIFT

(11) **EP 1 433 249 B1**
(45) Veröffentlichungstag und Bekanntmachung des Hinweises auf die Patenterteilung: **05.09.2007**
(21) Anmeldenummer: 02754420.4
(22) Anmeldetag: 24.07.2002
(51) Int. Cl.: H03C 3/09

(54) **ABGLEICHVERFAHREN FÜR EINE NACH DER ZWEI-PUNKT-MODULATION ARBEITENDE SCHALTUNG UND PLL-SCHALTUNG MIT EINER ABLGLEICHVORRICHTUNG**
COMPENSATING METHOD FOR A PLL CIRCUIT FUNCTIONING ACCORDING TO THE TWO-POINT-MODULATION AND PLL CIRCUIT PROVIDED WITH A COMPENSATING DEVICE
PROCEDE DE COMPENSATION D'UN CIRCUIT PLL FONCTIONNANT SELON LA MODULATION A DEUX POINTS ET CIRCUIT PLL DOTE D'UN DISPOSITIF DE COMPENSATION

(30) Priorität: 28.09.2001 DE 10147963
(43) Veröffentlichungstag der Anmeldung: 30.06.2004
(73) Patentinhaber: Infineon Technologies AG, 81669 München (DE)
(72) Erfinder: GREWING, Christian, 40489 Düsseldorf (DE); HAMMES, Markus, 46539 Dinslaken (DE); HANKE, André, 40468 Düsseldorf (DE); LI PUMA, Giuseppe, 44791 Bochum (DE)
(74) Vertreter: Lange, Thomas
(86) Internationale Anmeldenummer: PCT/DE2002/002709
(87) Internationale Veröffentlichungsnummer: WO 2003/032493

(56) Entgegenhaltungen:
- EP-A- 0 961 412
- WO-A-99/07065
- US-A- 5 027 087
- US-A- 5 483 203

## Beschreibung

Die Erfindung betrifft ein Abgleichverfahren für eine nach der Zwei-Punkt-Modulation arbeitende PLL-Schaltung und eine nach dem Prinzip der Zwei-Punkt-Modulation ausgelegte PLL-Schaltung mit einer Abgleichvorrichtung.

Eine aufwandsgünstige Realisierung eines Senderkonzepts für Transceiver in Mobilfunksystemen bieten Sender, welche einen nach der bekannten Zwei-Punkt-Modulation arbeitenden Modulator aufweisen. Eine PLL (Phase Locked Loop = Nachlaufsynchronisation)-Schaltung wird dabei als Frequenzsynthesizer eingesetzt und zur Phasen- oder Frequenzmodulation eines hochfrequenten Signals verwendet.

Ein Einprägen des Modulationssignals in die PLL-Schaltung erfolgt üblicherweise über einen im Rückkoppelzweig der PLL-Schleife enthaltenen programmierbaren Frequenzteiler. Dabei wird ein digitales Modulationssignal verwendet und zum fortwährenden Umprogrammieren des digitalen Frequenzteilers eingesetzt. Diese Form der Modulation, die auch als Ein-Punkt-Modulation bezeichnet wird, ist beispielsweise aus den Patentschriften US 4,965,531, US 6,008,703 und US 6,044,124 bekannt.

Um ein geringes Rauschen der PLL-Schaltung zu erreichen, wird die Bandbreite der Schaltung deutlich kleiner ausgelegt, als es für die Übertragung der modulierten Daten erforderlich ist. Daher wird zusätzlich zu der rein digitalen Modulation auch eine analoge Modulation zur Kompensation der beschränkten Bandbreite eingesetzt. Das gleichzeitige Einprägen eines digitalen und eines analogen Modulationssignals in eine PLL-Schaltung wird als Zwei-Punkt-Modulation bezeichnet.

Das Einprägen der digitalen und analogen Modulationssignale erfolgt an zwei unterschiedlichen Punkten der PLL-Schaltung. Wesentlich für die Funktionsweise der Zwei-Punkt-Modulation ist, dass neben der zeitlichen Gleichphasigkeit ein hohes Maß an Übereinstimmung der Amplituden der beiden verwendeten Modulationssignale benötigt wird. Aufgrund von Herstellungstoleranzen der Komponenten für die analoge Modulation treten jedoch Schwankungen in der Modulationssteilheit sowie der Amplitudenhöhe der Modulation auf. Aus diesem Grund ist es erforderlich, nach der Herstellung der PLL-Schaltung einen Amplitudenabgleich zwischen dem analogen und dem digitalen Modulationssignal vorzunehmen.

Sollen zudem Temperatureinflüsse berücksichtigt werden, muss ein derartiger Abgleich vor jedem Sendevorgang durchgeführt werden.

Ein Zwei-Punkt-Modulator sowie ein Verfahren zur Phasen- und Frequenzmodulation mit einer PLL-Schaltung ist in der deutschen Offenlegungsschrift DE 199 29 167 A1 beschrieben. Die Modulation erfolgt hierbei zum einen an einem Punkt der PLL-Schaltung, an dem sich ein Hochpass-Übertragungsverhalten für die Modulationsfrequenz ergibt. Zusätzlich erfolgt die Modulation an einem zweiten Punkt der PLL-Schaltung, an dem sich ein Tiefpass-Übertragungsverhalten für die Modulationsfrequenz ergibt. Die Modulation mit Tiefpass-Übertragungsverhalten erfolgt digital in einem Frequenzteiler im Rückführungszweig der PLL-Schaltung.

Ein bekanntes Verfahren zum Abgleichen einer PLL-Schaltung mit Zwei-Punkt-Modulation besteht darin, die Zwei-Punkt-Modulation der Schaltung im eingeschwungenen Zustand aufzuprägen und mit einem externen Mess-Empfänger das ausgesendete Signal zu empfangen und zu demodulieren. Abhängig von dem erhaltenen Demodulationsergebnis wird ein Abgleich der digitalen und analogen Modulationssignale vorgenommen. Aufgrund des nicht-linearen Verhaltens des schwingungserzeugenden Glieds - eines spannungsgesteuerten Oszillators VCO (Voltage Controlled Oscillator) - der PLL-Schaltung hinsichtlich der Frequenz als Funktion der Steuerspannung, muss dieser Abgleich jedoch für jeden Kanal vorgenommen werden. Für eine größere Anzahl an Kanälen resultiert daraus eine entsprechend lange Messdauer. Zusätzlich müssen die Abgleichinformationen in einem Speicher abgelegt werden. Ein weiterer Nachteil ist darin zu sehen, dass der Einfluss von Temperaturänderungen bei diesem Verfahren nicht berücksichtigt wird.

Das Empfangen sowie das Demodulieren des von der PLL-Schaltung erzeugten Signals kann auch durch das Empfangsteil des Transceivers vorgenommen werden. Dadurch erhöht sich allerdings der Schaltungsaufwand in nachteiliger Weise, da hierfür eine vollständige zweite PLL-Schaltung im Empfänger erforderlich wäre.

In der Schrift WO 99/07065 ist ein Abgleichverfahren für eine PLL beschrieben, die nach dem Prinzip der Zwei-Punkt-Modulation arbeitet. Bei diesem Verfahren wird die PLL durch Vorgabe verschiedener Teilerwerte N auf unterschiedliche Frequenzen abgestimmt und es werden die entsprechenden Spannungswerte am Eingang des VCO aufgezeichnet. Aus den auf diese Weise ermittelten Wertepaaren wird die Kennlinie des VCO berechnet. Mittels eines Prozessors wird die Kennlinie ausgewertet und es werden dabei Skalierwerte für die Einstellung des Modulationshubs des analogen Modulationssignals ermittelt.

Aufgabe der Erfindung ist es, ein Abgleichverfahren für eine PLL-Schaltung zu schaffen, mit dem ein schneller und genauer Amplitudenabgleich zwischen dem digitalen und dem analogen Modulationssignal erreicht werden kann. Ferner zielt die Erfindung darauf ab, eine PLL-Schaltung mit einer Abgleichvorrichtung zu schaffen, bei der ein schneller und genauer Amplitudenabgleich der Modulationssignale mit einem relativ einfachen Schaltungsaufbau erreicht werden kann.

Diese Aufgabenstellung wird durch ein Abgleichverfahren, das die Schritte nach Patentanspruch 1 aufweist, und durch eine PLL-Schaltung mit einer Abgleichvorrichtung, die die Merkmale nach Patentanspruch 9 aufweist, gelöst.

Bei einem Abgleichverfahren für eine nach der Zwei-Punkt-Modulation arbeitende PLL-Schaltung wird die PLL-Schaltung durch Einprägen eines ersten digitalen Modulationssignals auf eine erste Frequenz eingeregelt. Anschließend wird ein zweites digitales Modulationssignal in die PLL-Schaltung eingeprägt, wobei die PLL-Schaltung auf eine von der ersten Frequenz abweichende zweite Frequenz einregelt. Ein Differenzsignal, welches charakteristisch für die durch die beiden digitalen Modulationssignale bewirkte Änderung eines Steuersignals einer frequenzerzeugenden Einheit der PLL-Schaltung ist, wird erzeugt und aus der PLL-Schaltung ausgekoppelt. Das Differenzsignal wird mit einem Vergleichssignal, welches charakteristisch für einen Modulationshub eines analogen Modulationssignals ist, verglichen und abhängig von der bei dem Vergleich ermittelten Abweichung wird der Modulationshub derart geändert, dass die Abweichung beseitigt wird.

Dadurch kann bei dem erfindungsgemäßen Abgleichverfahren erreicht werden, dass das Demodulieren des von der PLL-Schaltung erzeugten Ausgangssignals zu Abgleichzwecken entfällt, da zum Abgleichen auf eine Abweichung zwischen zwei digitalen Modulationssignalen zurückgegriffen wird, die in einem für die Abweichung charakteristischen Differenzsignal dargestellt wird. Des Weiteren kann dadurch erreicht werden, dass ein relativ genaues und schnelles Abgleichen durchgeführt werden kann.

Ein vorteilhaftes Ausführungsbeispiel des erfindungsgemäßen Abgleichverfahrens kennzeichnet sich dadurch, dass das erste digitale Modulationssignal so eingeprägt wird, dass die PLL-Schaltung auf eine erste Frequenz eingeregelt wird, die durch das Subtrahieren einer Frequenz eines variabel wählbaren, digitalen Modulationshubs von einer Kanalmittenfrequenz gebildet wird. Sofern dann durch das Einprägen des zweiten digitalen Modulationssignals die PLL-Schaltung auf eine zweite Frequenz eingeregelt wird, die durch das Addieren der Frequenz des variabel wählbaren, digitalen Modulationshubs und der Kanalmittenfrequenz gebildet wird, kennzeichnet sich eine bevorzugte Ausführungsvariante dadurch, dass ein dem analogen Modulationssignal entsprechender Spannungswert zum Vergleichen mit dem dem Differenzsignal entsprechenden Spannungswert mit dem Faktor 2 multipliziert wird. Dadurch kann erreicht werden, dass ein dem Differenzsignal entsprechender analoger Spannungswert relativ groß ausgebildet werden kann und dadurch Abweichungen zwischen der digitalen Modulation und der analogen Modulation relativ genau ausgeglichen werden können.

Gemäß einer bevorzugten Auslegung ist einem Hauptpfad der PLL-Schaltung ein zur Steuersignalerzeugung beitragender Abgleichpfad parallel geschaltet. In diesem Fall kennzeichnet sich eine vorteilhafte Verfahrensvariante dadurch, dass der Abgleichpfad zumindest während des Einprägens des zweiten digitalen Modulationssignals aktiviert ist.

Ferner kann in vorteilhafter Weise vorgesehen sein, dass der Hauptpfad der PLL-Schaltung nach dem Einprägen des ersten digitalen Modulationssignals deaktiviert wird, indem ein von einer ersten Ladungspumpe im Hauptpfad erzeugter Strom auf den Wert Null gesetzt wird. Dadurch wird erreicht, dass eine dem ersten digitalen Modulationssignal entsprechende Spannung an einem Tuning-Eingang eines VCO während der folgenden Schritte (zweiter Einprägeschritt und ggf. Abgleichschritt) im wesentlichen konstant bleibt.

Das Aufrechterhalten der beim ersten Einprägeschritt an dem Tuning-Eingang des VCO erzeugten Spannung kann im allgemeinen jedoch auch auf andere Weise realisiert werden. Ein weiteres vorteilhaftes Ausführungsbeispiel kennzeichnet sich dadurch, dass der Hauptpfad der PLL-Schaltung nach dem Einprägen des ersten digitalen Modulationssignals aktiv gehalten wird und ein Strom durch die Ladungspumpe im Hauptpfad der PLL-Schaltung derart eingestellt wird, dass die Spannung am Tuning-Eingang des VCO im wesentlichen konstant gehalten wird. Dadurch kann erreicht werden, dass ein Ändern der (während des ersten Einprägeschrittes erzeugten) Spannung am Tuning-Eingang des VCO aufgrund von Leckströmen im Hauptpfad während des Abgleichens verhindert wird.

Ein weiterer Aspekt der Erfindung betrifft eine PLL-Schaltung, die für das Einprägen eines analogen und eines digitalen Modulationssignals nach dem Prinzip der Zwei-Punkt-Modulation ausgebildet ist. Einem Hauptpfad der PLL-Schaltung ist ein Abgleichpfad parallel geschaltet, der ein Auskoppelmittel zur Erzeugung eines Differenzsignals umfasst, welches für die Änderung eines Steuersignals einer frequenzerzeugenden Einheit bei Einprägen unterschiedlicher digitaler Modulationssignale in die PLL-Schaltung charakteristisch ist. Weiterhin umfasst der Abgleichpfad eine Vergleichseinheit zum Vergleichen des Differenzsignals mit einem Vergleichssignal, welches charakteristisch für einen Modulationshub eines analogen Modulationssignals ist, und eine Modulationseinheit, die den Modulationshub in Abhängigkeit von einem Ausgangssignal der Vergleichseinheit verändert.

Durch die erfindungsgemäße PLL-Schaltung mit dem Hauptpfad und dem parallel geschalteten Abgleichpfad ist ein relativ einfacher und aufwandsarmer Schaltungsaufbau realisiert, mit dem ein schneller und genauer Abgleich des digitalen und des analogen Modulationssignals durchgeführt werden kann.

Bei einem vorteilhaften Ausführungsbeispiel kann vorgesehen sein, dass über einen ersten Schalter das Differenzsignal an einen Modulationseingang eines VCO der PLL-Schaltung anlegbar ist. Weiterhin kann vorgesehen sein, dass der Abgleichpfad einen zweiten Schalter aufweist, in dessen geschlossener Stellung das Vergleichssignal an einem Eingang der Vergleichseinheit anliegt.

Weitere vorteilhafte Ausgestaltungen des Abgleichverfahrens und der PLL-Schaltung sind in den Unteransprüchen angegeben.

Die Erfindung wird nachfolgend anhand eines Ausführungsbeispiels unter Bezugnahme auf die Zeichnung näher erläutert. Es zeigen:
- Fig. 1: ein Blockschaltbild einer erfindungsgemäßen PLL-Schaltung mit einer Abgleichvorrichtung, und
- Fig. 2: ein schematisches Ablaufdiagramm des erfindungsgemäßen Abgleichverfahrens.

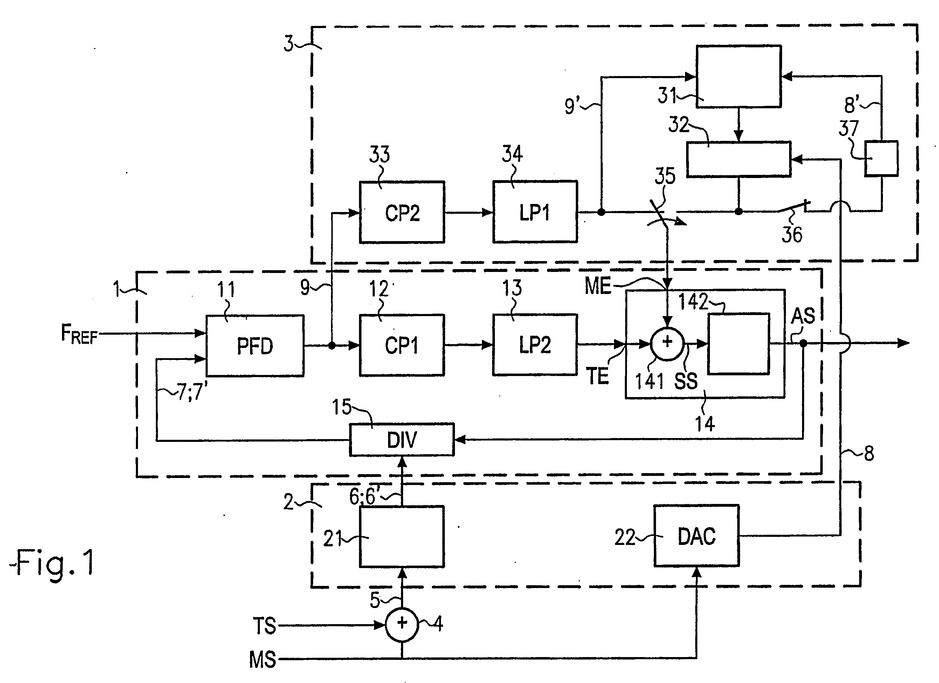

Eine nach der Zwei-Punkt-Modulation arbeitende PLL-Schaltung 1 (Fig. 1) ist mit einer Modulationsvorrichtung 2 und einem Abgleichpfad 3 elektrisch verbunden. Die PLL-Schaltung 1 weist in ihrem Hauptpfad einen Phasendetektor (PFD = Phase Frequency Detector) 11, eine erste Ladungspumpe (CP1 = Charge Pump 1) 12, ein erstes Schleifenfilter (LP1 = Loop Filter 1) 13 und einen spannungsgesteuerten Oszillator (VCO = Voltage Controlled Oscillator) 14 auf. Das Schleifenfilter 13 ist als Tiefpassfilter ausgeführt, wodurch höherfrequente Signalanteile geglättet werden. Der VCO 14 stellt das schwingungserzeugende Bauelement in der PLL-Schaltung 1 dar und weist einen Summationspunkt 141 und eine frequenzerzeugende Einheit 142 auf. Über einen Rückkoppelpfad, welcher sich vom Ausgang des VCO 14 zu einem Eingang des PFD 11 erstreckt und in dem ein programmierbarer Frequenzteiler (DIV = Divider) 15 angeordnet ist, wird die PLL-Schaltung 1 geschlossen. Der DIV 15 kann beispielsweise als Fraktional-N Frequenzteiler ausgeführt sein, wodurch auch eine Frequenzteilung durch eine nicht ganze Zahl ermöglicht wird.

Zur Aufbereitung eines Modulationssignals MS weist die Modulationsvorrichtung 2 eine Programmiereinheit 21 und einen Digital-Analog-Wandler (DAC = Digital Analog Converter) 22 auf.

Parallel zum Hauptpfad der PLL-Schaltung 1 ist der Abgleichpfad 3 geschaltet. Der Abgleichpfad 3 weist eine zweite Ladungspumpe (CP2) 33 und ein der Ladungspumpe 33 nachgeschaltetes zweites Schleifenfilter (LP2) 34 auf. Weiterhin ist eine Vergleichseinheit 31 und eine analoge Modulationseinheit 32 im Abgleichpfad 3 angeordnet. Abhängig vom durchgeführten Abgleichvorgang wird die Vergleichseinheit 31 und die analoge Modulationseinheit 32 über einen ersten Schalter 35 mit einem Modulationseingang ME des VCO 14 der PLL-Schaltung 1 elektrisch verbunden. Über einen zweiten Schalter 36 ist der Ausgang der analogen Modulationseinheit 32 mit einem zweiten Eingang der Vergleichseinheit 31 rückkoppelbar. Dieser Signalweg zwischen der Modulationseinheit 32 und der Vergleichseinheit 31 weist des Weiteren einen Multiplizierer 37 auf.

Bei der Zwei-Punkt-Modulation wird der PLL-Schaltung 1 über die Modulationsvorrichtung 2 ein analoges und ein digitales Modulationssignal eingeprägt. Da das analoge Modulationssignal im Gegensatz zum digitalen Modulationssignal, welches aufgrund seiner diskreten Natur keine Toleranzen aufweist, drift- und toleranzbehaftet ist, ist es erforderlich, die beiden Modulationssignale hinsichtlich ihrer Amplituden abzugleichen.

Ein Modulationssignal MS, welches im Ausführungsbeispiel als digitales Signal ausgeführt ist, wird an einem Summationspunkt 4 auf ein der PLL-Frequenzsynthese zugrunde liegendes Trägersignal TS addiert. Das resultierende Signal 5 liegt an einem Eingang der Programmiereinheit 21 an.

Die Programmiereinheit 21, die im Ausführungsbeispiel als Sigma-Delta Modulator ausgeführt ist, erzeugt an ihrem Ausgang ein erstes digitales Modulationssignal 6, welches an einen zweiten Eingang des DIV 15 anliegt. Das digitale Modulationssignal 6 gibt dabei ein Teilerverhältnis 1:N₁ an, wobei N₁ eine ganze Zahl darstellt. Dadurch wird das Modulationssignal MS mit einem durch die Modulation bestimmten (variablen) Frequenzteilungsverhältnis über den DIV 15 in den Rückkoppelzweig eingeprägt. Am Ausgang des DIV 15 wird ein erstes Frequenzteilungssignal 7 erzeugt, welches am ersten Eingang des PFD 11 anliegt.

An einem zweiten Eingang des PFD 11 liegt ein Referenzsignal mit einer entsprechenden Referenzfrequenz F_{REF} an. Die Referenzfrequenz F_{REF} kann beispielsweise durch einen nicht dargestellten Schwingquarz erzeugt werden. Dadurch wird am Ausgang des PFD 11 ein Signal erzeugt, das die Frequenz- und/oder Phasendifferenz zwischen dem Referenzsignal und dem ersten Frequenzteilungssignal 7 charakterisiert. Dieses Ausgangssignal 9 des PFD 11 wird zur Ansteuerung der Ladungspumpe 12 verwendet. In der Ladungspumpe 12 wird ein Strom erzeugt, der abhängig von dem Signal 9 ist, mit dem die Ladungspumpe 12 angesteuert wird. Mit dem in der Ladungspumpe 12 erzeugten Strom wird das Schleifenfilter 13 aufgeladen. Das Ausgangssignal des Schleifenfilters 13 ist ein Spannungssignal und liegt an dem Tuning-Eingang TE des VCO 14 an.

Am Ausgang des VCO 14 wird ein Ausgangssignal AS erzeugt, das am ersten Eingang des DIV 15 anliegt und welches durch das erste digitale Modulationssignal 6 moduliert ist.

Das Abgleichverfahren wird nachfolgend anhand der PLL-Schaltung gemäß Figur 1 erläutert:

In einem ersten Schritt wird das erste digitale Modulationssignal 6 mit einem ersten konstanten Teilerverhältnis 1:N₁ eingegeben. Das Teilerverhältnis 1:N₁ ist derart, dass die PLL-Schaltung 1 auf eine erste Frequenz F₁ einregelt, die einer Kanalmittenfrequenz f abzüglich einem digitalen Modulationshub Δf_{Dig} entspricht.

Indem die PLL-Schaltung 1 auf die Frequenz F₁ = f - Δf_{Dig} eingeregelt wird, stellt sich am Tuning-Eingang TE des VCO 14 ein Spannungswert V₁ ein, der dieser Frequenz F₁ entspricht, z.B. im Falle einer linearen Frequenz-Spannungs-Kennlinie des VCO 14 zu dieser Frequenz F₁ proportional ist.

Während dieses Einregelns der PLL-Schaltung 1 auf die Frequenz F₁ ist der Abgleichpfad 3 deaktviert, wobei das zweite Schleifenfilter (LP2) 34 auf den festen Spannungswert Null vorgeladen ist. Die Schalter 35 und 36 sind in den in Figur 1 dargestellten Positionen, die bei beiden Schaltern 35 und 36 als geschlossen bezeichnet werden.

Nachdem das Einregeln der PLL-Schaltung 1 auf die Frequenz F₁ abgeschlossen ist, wird in einem zweiten Schritt der Hauptpfad der PLL-Schaltung 1 deaktiviert, indem der Strom von der Ladungspumpe 12 auf den festen Wert Null eingestellt und die Regelschleife damit geöffnet wird. Dabei wird durch das integrierende Verhalten des Schleifenfilters 13 gewährleistet, dass die Spannung V₁ am Tuning-Eingang TE des VCO 14 bzw. an einem Summationspunkt 141 praktisch unverändert bleibt. Dies gilt zumindest für die Dauer des nachfolgenden Abgleichvorgangs. Ferner wird nun der Abgleichpfad 3, das heißt die zweite Ladungspumpe 33 und das zweite Schleifenfilter 34, aktiviert und dadurch die Regelschleife über den Abgleichpfad 3 geschlossen. Die Schalterstellung der beiden Schalter 35 und 36 bleibt dabei unverändert.

Anschließend wird die Programmiereinheit 21 umprogrammiert, so dass am Ausgang der Programmiereinheit 21 ein zweites digitales Modulationssignal 6' erzeugt wird, welches ein zweites konstantes Teilerverhältnis 1:N₂ angibt.

Das zweite Teilerverhältnis 1:N₂ wird derart eingestellt, dass das Ausgangssignal AS am VCO 14 eine zweite Frequenz F₂ = f + Δf_{Dig} aufweist. Die PLL-Schaltung wird somit auf die zweite Frequenz F₂ eingeregelt. Da am Tuning-Eingang TE weiterhin der Spannungswert V₁ anliegt, stellt sich am Modulationsseingang ME des VCO 14 ein Spannungswert V₂ ein, der dem doppelten digitalen Modulationshub 2Δf_{Dig} entspricht.

Dieser Spannungswert V₂ resultiert daraus, dass die Ausgangsfrequenz am VCO 14 der zweiten Frequenz F₂ entspricht, auf die die PLL-Schaltung 1 eingeregelt wird. An der frequenzerzeugenden Einheit 142 liegt daher ein Steuersignal SS an, dessen Spannung V₃ diese Frequenz F₂ erzeugt. Aufgrund der Summationsbedingung am Summationspunkt 141 sowie der festen Spannung V₁ am Tuning-Eingang TE, ergibt sich daher am Modulationseingang ME ein Spannungswert V₂(2Δf_{Dig}) = V₃(f + Δf_{Dig}) - V₁(f - Δf_{Dig}).

Zum Vergleichen des Differenzsignals 9' am Ausgang des zweiten Tiefpassfilters 34 mit einem analogen Modulationssignal wird in einem dritten Schritt das Modulationssignal MS durch den DAC 22 in ein analoges Modulationssignal 8 gewandelt und liegt an einem zweiten Eingang der analogen Modulationseinheit 32 an. Das analoge Modulationssignal 8 bewirkt eine Frequenz F₃ = f + Δf_{Ana} am Ausgang des VCO. Der dieser Frequenz F₃ entsprechende Spannungswert am Modulationseingang ME muss im abgeglichenen Zustand halb so groß wie der Spannungswert V₂ sein. Zum Vergleichen mit dem Spannungswert V₂ wird dieser Spannungswert am Ausgang der Modulationseinheit 32 abgegriffen und nach einer Verdoppelung in dem Multiplizierer 37 als Vergleichssignal 8' an einen zweiten Eingang der Vergleichseinheit 31 angelegt.

Der Spannungswert V₂ des Differenzsignals 9' liegt gleichzeitig an einem ersten Eingang der Vergleichseinheit 31 an, die im Ausführungsbeispiel als Komparator ausgeführt ist. Die Schalterpositionen sind weiterhin unverändert, das heißt die Vergleichseinheit 31 und die analoge Modulationseinheit 32 sind durch die Schalterstellung des ersten Schalters 35 vom Modulationseingang ME des VCO 14 entkoppelt.

Eine in der Vergleichseinheit 31 ermittelte Abweichung zwischen dem Spannungswert V₂ des Differenzsignals 9' und dem entsprechenden Spannungswert des Vergleichssignals 8' wird beseitigt, indem der Modulationshub des am Ausgang der analogen Modulationseinheit 32 bereitgestellten analogen Modulationssignals verändert wird.

Alternativ kann die dem Differenzsignal 9' entsprechende Spannung V₂ am Eingang der Vergleichseinheit 31, beispielsweise durch einen Kondensator, gespeichert werden und anschließend mit dem Spannungswert des Vergleichssignals 8' verglichen werden.

Nachdem der Abgleichvorgang abgeschlossen ist, wird der Schalter 35 umgeschaltet, der Schalter 36 geöffnet und die Ladungspumpe 33 und das Schleifenfilter 34 deaktiviert. Der Hauptpfad der PLL-Schaltung 1 wird aktiviert.

Die PLL-Schaltung 1 für die Zwei-Punkt-Modulation ist nun abgeglichen und kann ihren Betrieb aufnehmen. Das digitale und das analoge Modulationssignal überlagern sich dabei und es ergibt sich infolge des beschriebenen Abgleichvorgangs ein frequenzunabhängiges Übertragungsverhalten der PLL-Schaltung 1.

Das Erzeugen des Vergleichssignals 8' kann auch in der Vergleichseinheit 31 oder in der analogen Modulationseinheit 32 durchgeführt werden.

Wird als Modulationssignal MS ein analoges Signal verwendet, kann die Modulationsvorrichtung 2 beispielsweise auch derart ausgeführt sein, dass der DAC 22 nicht benötigt wird aber dafür eine entsprechende Signalwandlung im digitalen Modulationspfad durchgeführt wird.

Das Abgleichen der an die Vergleichseinheit 31 angelegten Signale kann beispielsweise in einem iterativen Prozess erfolgen. In diesem Fall erfolgt ein approximativer Abgleich der Modulationsamplituden mit wechselweiser Aktualisierung des Vergleichssignals 8' und Bewertung des daraufhin erhaltenen, geänderten Ausgangssignals der Vergleichseinheit 31. Bei erfolgter Beseitigung der Spannungsdifferenz an der Vergleichseinheit 31 ist der Abgleich zwischen digitalem und analogem Modulationshub erreicht.

Es kann auch vorgesehen sein, dass während des Abgleichens der Hauptpfad der PLL-Schaltung 1 aktiv gehalten wird, indem die erste Ladungspumpe 12 mit einem kleinen Strom betrieben wird. Aufgrund des reduzierten Stroms der ersten Ladungspumpe 12 kann der Hauptpfad der PLL-Schaltung 1 der Modulation nicht folgen und die Spannung am Tuning-Eingang TE des VCO 14 bleibt konstant. Dadurch kann erreicht werden, dass ein Spannungsverlust am Tuning-Eingang TE des VCO 14 bedingt durch Leckströme, die bei einem deaktivierten Hauptpfad auftreten können, kompensiert werden.

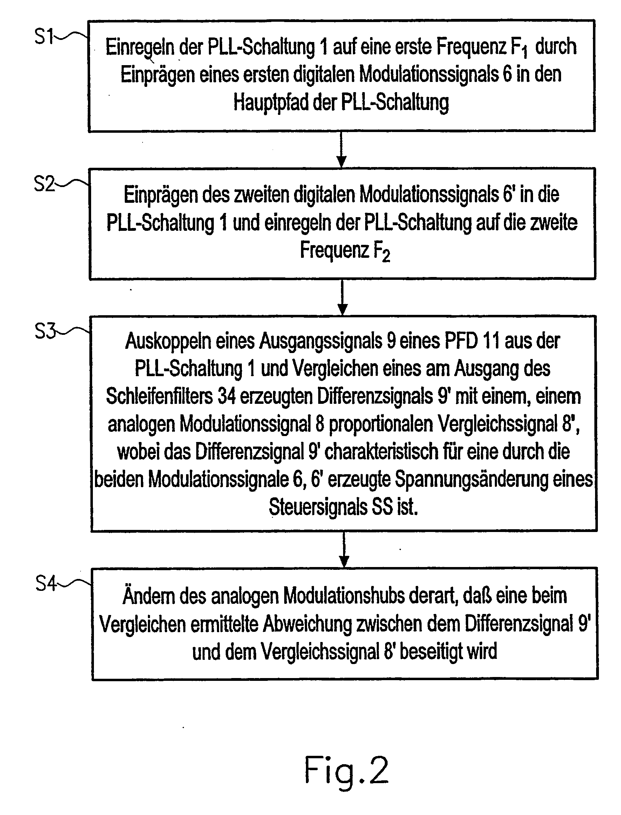

In Fig. 2 ist ein schematisches Ablaufdiagramm des Abgleichverfahrens aufgezeigt. In dem ersten Verfahrensschritt S1 wird die PLL-Schaltung 1 (Fig. 1) 1 auf eine Frequenz F₁ = f - Δf_{Dig} eingeregelt, indem das erste digitale Modulationssignal 6 in den Hauptpfad der PLL-Schaltung 1 eingeprägt wird. Im nachfolgenden zweiten Verfahrensschritt S2 wird das zweite digitale Modulationssignal 6' in die PLL-Schaltung 1 eingeprägt und die PLL-Schaltung auf die Frequenz F₂ = f + Δf_{Dig} eingeregelt. Ein Ausgangssignal 9 wird aus der PLL-Schaltung 1 ausgekoppelt und ein Differenzsignal 9' erzeugt, welches charakteristisch für die durch die beiden digitalen Modulationssignale 6 und 6' bewirkte Spannungsänderung eines Steuersignals SS am Eingang der frequenzerzeugenden Einheit 142 ist. Das Differenzsignal 9' wird mit dem dem analogen Modulationssignal 8 proportionalen Vergleichssignal 8' gemäß Verfahrensschritt S3 verglichen. Die bei dem Vergleichen ermittelte Abweichung zwischen dem Differenzsignal 9' und dem Vergleichssignal 8' wird beseitigt, indem der analoge Modulationshub entsprechend dem Verfahrensschritt S4 verändert wird.

## Patentansprüche

1. Abgleichverfahren für eine nach der Zwei-Punkt-Modulation arbeitende PLL-Schaltung (1), mit den folgenden Schritten:
(a) Einprägen eines ersten digitalen Modulationssignals (6) in die PLL-Schaltung (1), wobei diese auf eine erste Frequenz (F₁) einregelt,
(b) Einprägen eines zweiten digitalen Modulationssignals (6') in die PLL-Schaltung (1), wobei diese auf eine zweite Frequenz (F₂) einregelt, welche unterschiedlich zu der ersten Frequenz (F₁) ist,
(c) Auskoppeln eines Differenzsignals (9'), welches charakteristisch für die durch die beiden Modulationssignale (6, 6') bewirkte Änderung eines Steuersignals (SS) einer frequenzerzeugenden Einheit (142) der PLL-Schaltung (1) ist,
(d) Vergleichen des Differenzsignals (9') mit einem Vergleichssignal (8'), welches charakteristisch für einen Modulationshub (Δf_{Ana}) eines analogen Modulationssignals ist, und
(e) Ändern des Modulationshubs (Δf_{Ana}) derart, dass eine bei dem Vergleich ermittelte Abweichung zwischen dem Differenzsignal (9') und dem Vergleichssignal (8') beseitigt wird.

2. Verfahren nach Anspruch 1,
**dadurch gekennzeichnet,**
**dass** durch das Einprägen des ersten digitalen Modulationssignals (6) die PLL-Schaltung (1) auf eine erste Frequenz (F₁) eingeregelt wird, die durch das Subtrahieren einer Frequenz eines variabel wählbaren, digitalen Modulationshubs (Δf_{Dig}) von einer Kanalmittenfrequenz (f) gebildet wird.

3. Verfahren nach einem der Ansprüche 1 oder 2,
**dadurch gekennzeichnet,**
**dass** durch das Einprägen des zweiten digitalen Modulationssignals (6') die PLL-Schaltung (1) auf eine zweite Frequenz (F₂) eingeregelt wird, die durch das Addieren der Frequenz des variabel wählbaren, digitalen Modulationshubs (Δf_{Dig}) und der Kanalmittenfrequenz (f) gebildet wird.

4. Verfahren nach einem der vorhergehenden Ansprüche,
**dadurch gekennzeichnet,**
**dass** ein dem analogen Modulationshub entsprechender Spannungswert (V₂) zum Vergleichen mit dem dem Differenzsignal (9') entsprechenden Spannungswert mit dem Faktor 2 multipliziert wird.

5. Verfahren nach einem der vorhergehenden Ansprüche,
**dadurch gekennzeichnet,**
**dass** einem Hauptpfad der PLL-Schaltung (1) ein zur Steuersignalerzeugung beitragender Abgleichpfad (3) parallel geschaltet ist, mit dem Schritt:
- Aktivieren des Abgleichpfads (3) zumindest während des Einprägens des zweiten digitalen Modulationssignals (6').

6. Verfahren nach Anspruch 5,
**gekennzeichnet durch** den Schritt:
- Deaktivieren des Hauptpfades der PLL-Schaltung (1) nach dem Einprägen des ersten digitalen Modulationssignals (6), indem ein von einer ersten Ladungspumpe (12) im Hauptpfad erzeugter Strom auf den Wert Null gesetzt wird.

7. Verfahren nach dem Anspruch 5,
**dadurch gekennzeichnet,**
**dass** der Hauptpfad der PLL-Schaltung (1) während des Abgleichens aktiv gehalten wird und ein Strom durch eine Ladungspumpe (12) im Hauptpfad der PLL-Schaltung (1) derart eingestellt wird, dass die Spannung (V₁) an einem Tuning-Eingang (TE) eines VCO (14) der PLL-Schaltung (1) im wesentlichen konstant gehalten wird.

8. Verfahren nach einem der vorhergehenden Ansprüche,
**dadurch gekennzeichnet,**
**dass** das erste und das zweite digitale Modulationssignal (6, 6') über einen im Rückführungszweig der PLL-Schaltung (1) angeordneten Frequenzteiler DIV (15) eingeprägt werden.

9. PLL-Schaltung, die für das Einprägen eines analogen und eines digitalen Modulationssignals nach der Zwei-Punkt-Modulation ausgelegt ist,
**dadurch gekennzeichnet,**
**dass** einem Hauptpfad der PLL-Schaltung ein Abgleichpfad (3) parallel geschaltet ist, der
- ein Auskoppelmittel (33, 34) zur Erzeugung eines Differenzsignals (9') umfasst, welches für die Änderung eines Steuersignals (SS) einer frequenzerzeugenden Einheit (142) der PLL-Schaltung (1) bei Einprägen unterschiedlicher digitaler Modulationssignale (6, 6') in die PLL-Schaltung (1) verwendet wird,
- eine Vergleichseinheit (31) zum Vergleichen des Differenzsignals (9') mit einem Vergleichssignal (8') umfasst, welches für einen Modulationshub (Δf_{Ana}) eines analogen Modulationssignals (8) verwendet wird, und
- eine Modulationseinheit (32) umfasst, die den Modulationshub (Δf_{Ana}) des analogen Modulationssignals (8) in Abhängigkeit von einem Ausgangssignal der Vergleichseinheit (31) verändert.

10. PLL-Schaltung nach Anspruch 9,
**dadurch gekennzeichnet,**
**dass** das Auskoppelmittel (33, 34) eine Ladungspumpe (33) und ein der Ladungspumpe (33) nachgeschaltetes Schleifenfilter (34) umfasst.

11. PLL-Schaltung nach einem der Ansprüche 9 oder 10,
**gekennzeichnet durch**
einen ersten Schalter (35), über welchen das Differenzsignal (9') an einen Modulationseingang (ME) eines VCO (14) der PLL-Schaltung (1) anlegbar ist.

12. PLL-Schaltung nach einem der Ansprüche 9 bis 11,
**gekennzeichnet durch**
einen zweiten Schalter (36), in dessen geschlossener Stellung das Vergleichssignal (8') an einem Eingang der Vergleichseinheit (31) anliegt.

## Claims

1. Compensating method for a PLL circuit (1) that functions according to two-point modulation, with the following steps:
(a) injecting a first digital modulation signal (6) into the PLL circuit (1), the latter being tuned to the first frequency (F₁),
(b) injecting a second digital modulation signal (6') into the PLL circuit (1), the latter being tuned to a second frequency (F₂), which is different from the first frequency (F₁),
(c) coupling out a differential signal (9'), which is characteristic of the change of a control signal (SS) of a frequency-generating unit (142) of the PLL circuit (1) that is brought about by the two modulation signals (6, 6'),
(d) comparing the differential signal (9') with a comparison signal (8'), which is characteristic of a modulation amplitude (Δf_{Ana}) of an analog modulation signal, and
(e) changing the modulation amplitude (Δf_{Ana}) in such a way that a deviation between the differential signal (9') and the comparison signal (8') that is determined in the comparison is eliminated.

2. Method according to Claim 1, **characterized in that** the injection of the first digital modulation signal (6) causes the PLL circuit (1) to be tuned to a first frequency (F₁), which is formed, by subtracting a frequency of a variably selectable, digital modulation amplitude (Δf_{Dig}) from a channel center frequency (f).

3. Method according to either of Claims 1 and 2, **characterized in that** the injection of the second digital modulation signal (6') causes the PLL circuit (1) to be tuned to a second frequency (F₂), which is formed by adding the frequency of the variably selectable, digital modulation amplitude (Δf_{Dig}) and the channel center frequency (f).

4. Method according to one of the preceding claims, **characterized in that** a voltage value (V₂) corresponding to the analog modulation amplitude is multiplied by a factor of 2 for the comparison with the voltage value corresponding to the differential signal (9').

5. Method according to one of the preceding claims, **characterized in that** a compensating path (3) contributing to the control signal generation is connected in parallel with a main path of the PLL circuit (1), with the step of:
- activating the compensating path (3) at least during the injection of the second digital modulation signal (6').

6. Method according to Claim 5, **characterized by** the step of:
- deactivating the main path of the PLL circuit (1) after the injection of the first digital modulation signal (6), in that a current generated by a first charge pump (12) in the main path is set to the value of zero.

7. Method according to Claim 5, **characterized in that** the main path of the PLL circuit (1) is kept active during the compensation and a current is set by a charge pump (12) in the main path of the PLL circuit (1) in such a way that the voltage (V₁) at a tuning input (TE) of a VCO (14) of the PLL circuit (1) is kept substantially constant.

8. Method according to one of the preceding claims, **characterized in that** the first digital modulation signal (6) and the second digital modulation signal (6') are injected via a frequency divider DIV (15) arranged in the feedback path of the PLL circuit (1).

9. PLL circuit, which is designed for the injection of an analog modulation signal and a digital modulation signal according to two-point modulation, **characterized in that** connected in parallel with a main path of the PLL circuit (1) is a compensating path (3), which
- comprises a coupling-out means (33, 34) for generating a differential signal (9'), which is used for the change of a control signal (SS) of a frequency-generating unit (142) of the PLL circuit (1) when different digital modulation signals (6, 6') are injected into the PLL circuit (1),
- comprises a comparison unit (31) for comparing the differential signal (9') with a comparison signal (8'), which is used for a modulation amplitude (Δf_{Ana}) of an analog modulation signal (8), and
- comprises a modulation unit (32), which changes the modulation amplitude (Δf_{Ana}) of the analog modulation signal (8) in dependence on an output signal of the comparison unit (31).

10. PLL circuit according to Claim 9, **characterized in that** the coupling-out means (33, 34) comprises a charge pump (33) and a loop filter (34) connected downstream of the charge pump (33).

11. PLL circuit according to either of Claims 9 and 10, **characterized by** a first switch (35), by means of which the differential signal (9') can be applied to a modulation input (ME) of a VCO (14) of the PLL circuit (1).

12. PLL circuit according to one of Claims 9 to 11, **characterized by** a second switch (36), in the closed position of which the comparison signal (8') is present at an input of the comparison unit (31).

## Revendications

1. Procédé de réglage d'un circuit (1) PLL fonctionnant suivant la modulation à deux points, comprenant le stade suivant :
a) injection d'un premier signal (6) numérique de modulation dans le circuit (1) PLL, celui-ci réglant à une première fréquence (F₁),
b) injection d'un deuxième signal (6') numérique de modulation d'un circuit (1) PLL, celui-ci réglant à une deuxième fréquence (F₂) qui est différente de la première fréquence (F₁),
c) sortie d'un signal (9') de différence, caractéristique de la modification, provoquée par les deux signaux (6, 6') de modulation, d'un signal (SS) de commande d'une unité (142) produisant une fréquence du circuit (1) PLL,
d) comparaison du signal (9') de différence avec un signal (8') de comparaison, caractéristique de l'amplitude (Δf_{Ana}) de modulation d'un signal analogique de modulation.
e) modification de l'amplitude (Δf_{Ana}) de façon à éliminer un écart, déterminé par la comparaison, entre le signal (9') de différence et le signal (8') de comparaison.

2. Procédé suivant la revendication 1,
**caractérisé**
**en ce que** l'on règle, par l'injection du premier signal (6) numérique de modulation, le circuit (1) PLL à une première fréquence (F₁) qui est formée en soustrayant une fréquence d'une amplitude (Δf_{Dig}) numérique de modulation pouvant être choisie de manière variable, d'une fréquence (f) moyenne de canal.

3. Procédé suivant l'une des revendications 1 ou 2,
**caractérisé**
**en ce que** l'on règle, par l'injection du deuxième signal (6') numérique de modulation, le circuit (1) PLL à une deuxième fréquence (F₂) qui est formée par l'addition de la fréquence d'amplitude (Δf_{Dig}) numérique de modulation, pouvant être choisie de manière variable, à la fréquence (f) moyenne de canal.

4. Procédé suivant l'une des revendications précédentes,
**caractérisé**
**en ce que** l'on multiplie par le facteur 2 une valeur (V₂) de tension correspondante à l'amplitude de modulation analogique pour la comparaison à la valeur de tension correspondante au signal (9') de différence.

5. Procédé suivant l'une des revendications précédentes,
**caractérisé**
**en ce qu'**un trajet principal du circuit (1) PLL est monté en parallèle à un trajet (3) de réglage contribuant à la production du signal de commande, comprenant le stade :
- d'activation du trajet (3) de réglage au moins pendant l'injection du deuxième signal (6') numérique de modulation.

6. Procédé suivant la revendication 5,
**caractérisé par** le stade :
- de désactivation du trajet principal du circuit (1) PLL après l'injection du premier signal (6) numérique de modulation, notamment en mettant à la valeur zéro un courant produit par une première pompe (12) de charge dans le trajet principal.

7. Procédé suivant la revendication 5,
**caractérisé en ce que** l'on maintient actif le trajet principal du circuit (1) PLL pendant le réglage et on règle un courant par une pompe (12) de charge dans le trajet principal du circuit (1) PLL de façon à ce que la tension (V₁) soit maintenue sensiblement constante à une entrée (TE) d'accord d'un VCO (14) du circuit (1) PLL.

8. Procédé suivant l'une des revendications précédentes,
**caractérisé**
**en ce que** le premier et le deuxième signal (6, 6') numérique de modulation sont injectés par un diviseur DIV (15) de fréquence monté dans la branche de retour du circuit (1) PLL.

9. Circuit PLL, qui est conçu pour l'injection d'un signal analogique de modulation et d'un signal numérique de modulation, suivant la modulation à deux points
**caractérisé**
**en ce qu'**un trajet (3) de réglage et monté en parallèle au trajet principal du circuit PLL, et
- comprend un moyen (33, 34) de sortie pour la production d'un signal, (9') de différence, qui est utilisé pour la modification d'un signal (SS) de commande d'une unité, (142) produisant une fréquence, du circuit (1) PLL lors de l'injection dans le circuit (1) PLL de signaux (6, 6') numérique de modulation différente,
- comprend une unité (31) de comparaison, pour comparer le signal (9') de différence à un signal (8') de comparaison qui est utilisé pour une amplitude (Δf_{Ana}) de modulation d'un signal (8) analogique de modulation et
- comprend une unité (32) de modulation, qui modifie l'amplitude (Δf_{Ana}) de modulation du signal (8) analogique de modulation en fonction d'un signal de sortie de l'unité (31) de comparaison.

10. Circuit PLL suivant la revendication 9,
**caractérisé**
**en ce que** le moyen (33, 34) de sortie comprend une pompe (33) de charge et un filtre (34) en boucle monté en aval de la pompe (33) de charge.

11. Circuit PLL suivant l'une des revendications 9 ou 10,
**caractérisé**
**par** un premier commutateur (35) par lequel le signal (9') de différence peut être appliqué à une entrée (ME) de modulation d'un VCO (14) du circuit (1) PLL.

12. Circuit PLL suivant l'une des revendications 9 à14,
**caractérisé,**
**par** un deuxième commutateur (36) dans la position fermée duquel le signal (8') de comparaison s'applique à une entrée de l'unité (31) de comparaison.
